# EUROPÄISCHE PATENTSCHRIFT

(11) **EP 1 503 473 B1**
(45) Veröffentlichungstag und Bekanntmachung des Hinweises auf die Patenterteilung: **01.07.2009**
(21) Anmeldenummer: 04017574.7
(22) Anmeldetag: 24.07.2004
(51) Int. Cl.: H02H 9/04, H01L 27/02

(54) **Monolithisch integrierbare Schaltungsanordnung zum Überspannungsschutz**
Monolithically integrated circuit for overvoltage protection
Circuit integré monolithique pour la protection contre les surtensions

(30) Priorität: 28.07.2003 DE 10335383
(43) Veröffentlichungstag der Anmeldung: 02.02.2005
(73) Patentinhaber: ATMEL Germany GmbH, 74072 Heilbronn (DE)
(72) Erfinder: Dietz, Franz, Dipl.-Ing., 74081 Heilbronn (DE); Hehn, Lars, Dipl.-Ing., 74080 Heilbronn (DE); Klaussner, Manfred, Dipl.-Ing., 74080 Heilbronn (DE); Koch, Anton, Dipl.-Ing., 74834 Elztal-Auerbach (DE)
(74) Vertreter: Müller, Wolf-Christian

(56) Entgegenhaltungen:
- EP-A- 1 178 531
- US-A- 5 448 180
- US-A- 5 986 862

## Beschreibung

Die Erfindung bezieht sich auf eine monolithisch integrierbare Schaltungsanordnung zum Überspannungsschutz eines oder mehrerer Anschlüsse einer integrierten Schaltung nach dem Oberbegriff des Anspruchs 1.

Bei der Handhabung und dem Betrieb integrierter Schaltungen ist darauf zu achten, den Schaltkreis bzw. dessen Anschlüsse oder Anschlusspins vor Überspannungen zu schützen, die eine Störung des regulären Betriebs bzw. eine Beschädigung des Schaltkreises verursachen können. Derartige Überspannungen entstehen beispielsweise durch kapazitive und/oder induktive Kopplung auf gemeinsam geführten Leitungen. So können bei CAN-Bussystemen, deren Busleitung in Kabelbäumen von Kraftfahrzeugen geführt ist, gegenüber einer Substrat- bzw. Bezugsspannung des integrierten Schaltkreises, die das niedrigste Potential des integrierten Schaltkreises darstellt, positive sowie negative Überspannungen mit einer Amplitude von bis zu 45V auftreten.

Eine weitere Ursache von Überspannungen sind sogenannte Electrostatic-Discharge(ESD)-Vorgänge, bei denen energiearme Spannungsspitzen hoher Amplitude entstehen.

Herkömmliche Schaltungsanordnungen zum Überspannungsschutz integrierter Schaltungen begrenzen Überspannungen, die im Vergleich zur Bezugsspannung positiv sind, auf einen einstellbaren Grenzwert. Wenn die am Anschluss anstehende Spannung den einstellbaren Grenzwert überschreitet, werden Elemente zur Spannungsbegrenzung leitend und begrenzen so die am Anschluss anstehende Spannung. Dieser Mechanismus wird auch als Klemm- oder Clamp-Mechanismus bezeichnet.

Üblicherweise sind die Schaltungsanordnungen zum Überspannungsschutz in die zu schützende integrierte Schaltung monolithisch integriert, da diskrete bzw. externe Bauelemente das Schaltungsdesign erheblich erschweren sowie keine entsprechende Betriebssicherheit gewährleisten können.

Wenn an einem Anschluss im Vergleich zu seiner Substratspannung negative Spannungen anstehen, können parasitäre Box-, Bulk- bzw. Substrat-Dioden in Flussrichtung gepolt werden, wodurch eine Funktionsstörung bzw. Beschädigung der integrierten Schaltung verursacht werden kann. Derartige negative Überspannungen werden herkömmlicherweise auf ein Niveau festgelegt bzw. geklemmt, das um eine Diodendurchflussspannung einer als Spannungsbegrenzungselement dienenden Schutzdiode unter dem Substratpotential liegt, d.h. wenn die am Anschluss anstehende Spannung die Diodendurchflussspannung betragsmäßig überschreitet, wird die Schutzdiode leitend. Die Spannungsgrenzen, an denen ein Clamp-Mechanismus einsetzt, sind folglich für positive und negative Überspannungen bei diesen herkömmlichen Schutzbeschaltungen unterschiedlich.

Dieser Unterschied kann insbesondere bei einer differentiellen Datenübertragung zu Problemen führen. Bei einer derartigen Datenübertragung werden zwei Datenleitungen benötigt, wobei die Spannungsdifferenz zwischen diesen Datenleitungen zur Kodierung des zu übertragenden Zeichens verwendet wird. Jeweils eine Datenleitung wird an einen zugehörigen Anschluss einer Treiberstufe angeschlossen, wobei die beiden Anschlüsse ein Anschlusspaar bilden. Wenn eine logische "1" übertragen wird, liegt an beiden Anschlüssen das gleiche Potential an. Wenn eine logische "0" übertragen wird, nimmt ein Anschluss ein hohes Potential im Bereich einer Versorgungsspannung und der andere ein niedriges Potential im Bereich der Bezugsspannung an. Diese Art der Datenübertragung ist gegenüber Gleichtaktstörungen auf beiden Leitungen im wesentlichen unempfindlich, sofern die Anschlüsse der Treiberstufe positive und negative Spannungsamplituden zulassen, ohne sie, insbesondere durch einen Clamp-Mechanismus, zu verfälschen.

In der US 5,448,180 ist eine Treiberstufe für einen CAN-Bus beschreiben, die eine Schutzbeschaltung beispielsweise gegen Kurzschlüsse einer Datenleitung gegen Masse oder Versorgungsspannung umfasst.

Der Erfindung liegt als technisches Problem die Bereitstellung einer monolithisch integrierbaren Schaltungsanordnung zum Überspannungsschutz der eingangs genannten Art zugrunde, die positive und/oder negative Überspannungen an Anschlüssen einer integrierten Schaltung wirksam begrenzt, Verfälschungen eines Nutzsignals durch Clamp-Mechanismen weitgehend verhindert und kostengünstig ohne Sonderbauelemente herstellbar ist.

Die Erfindung löst dieses Problem durch die Bereitstellung einer Schaltungsanordnung mit den Merkmalen des Anspruchs 1 oder 2.

Bei der erfindungsgemäßen Schaltungsanordnung nach Anspruch 1 oder 2 sind als Überspannungsschutz eines oder mehrerer Anschlüsse einer Low-Side-Treiberstufe bzw. einer High-Side-Treiberstufe für den Anschluss oder wenigstens einen der Anschlüsse jeweils eine erste Zenerdiode und eine erste Diode vorgesehen, die in Serie zwischen den Anschluss und das Bezugspotential eingeschleift sind, wobei die erste Zenerdiode in Flussrichtung und die erste Diode in Sperrrichtung beschaltet sind.

Die erste Diode verhindert ein Durchschalten der ersten Zenerdiode bei positiven Spannungen am Anschluss. Bei negativen Spannungen am Anschluss arbeitet die erste Diode in Durchlassrichtung und die Zenerdiode in Sperrrichtung. Wenn die negative Spannung am Anschluss die Zenerspannung der ersten Zenerdiode und die Durchflussspannung der ersten Diode überschreitet, wird ein aus der ersten Zenerdiode und der ersten Diode gebildeter Strompfad leitend und die Spannung am Eingang wird auf die Summe aus Zenerspannung und Diodendurchflussspannung begrenzt. Insbesondere nimmt die erste Zenerdiode die Energie negativer ESD-Pulse auf, wodurch eine Zerstörung der Schaltung verhindert wird. Durch geeignete Wahl der Zenerspannung kann die Spannungsschwelle bis zum Einsetzen des Clamp-Mechanismus eingestellt werden.

Bei der erfindungsgemäßen Schaltungsanordnung nach Anspruch 1 ist als Überspannungsschutz des oder der mehreren Anschlüsse der Low-Side-Treiberstufe, bei der dem jeweiligen Anschluss ein n-Kanal-MOSFET zugeordnet ist, für den Anschluss oder wenigstens einen der Anschlüsse des weiteren eine zweite Diode zwischen diesen Anschluss und einen Anschluss des n-Kanal-MOSFET in Flussrichtung eingeschleift und eine zweite Zenerdiode ist zwischen den Anschluss des n-Kanal-MOSFET und das Bezugspotential in Sperrrichtung eingeschleift.

Die zweite Diode verhindert bei negativen Anschlussspannungen einen Stromfluss durch eine Bulk-Diode des n-Kanal-MOSFET, die dieser zwischen seinem Drain-Anschluß und Bezugspotential aufweist. Die zweite Zenerdiode dient zur Begrenzung einer positiven Anschlussspannung auf einen Maximalwert und dient insbesondere zur Energieaufnahme positiver ESD-Pulse, wodurch eine Zerstörung der Schaltung verhindert wird. Wenn die positive Spannung am Anschluss die Zenerspannung der zweiten Zenerdiode und die Durchflussspannung der zweiten Diode überschreitet, wird ein aus der zweiten Zenerdiode und der zweiten Diode gebildeter Strompfad leitend und die Spannung am Eingang wird auf die Summe aus Zenerspannung und Diodendurchflussspannung begrenzt. Durch geeignete Wahl der Zenerspannung kann die Spannungsschwelle bis zum Einsetzen des Clamp-Mechanismus eingestellt werden.

Bei der erfindungsgemäßen Schaltungsanordnung nach Anspruch 2 ist als Überspannungsschutz des oder der mehreren Anschlüsse der High-Side-Treiberstufe, bei der dem jeweiligen Anschluss ein p-Kanal-MOSFET zugeordnet ist, für den Anschluss oder wenigstens einen der Anschlüsse des weiteren eine zweite Diode zwischen die Versorgungsspannung und einen Anschluss des p-Kanal-MOSFET in Flussrichtung eingeschleift und eine zweite Zenerdiode ist zwischen den Anschluss des p-Kanal-MOSFET und das Bezugspotential in Sperrrichtung eingeschleift.

Die zweite Diode verhindert bei positiven Anschlussspannungen, die größer als die Versorgungsspannung sind, einen Stromfluss durch eine Bulk-Diode des p-Kanal-MOSFET, die dieser zwischen seinem Drain-Anschluß und seinem Source-Anschluss aufweist, in die Versorgungsspannung. Die zweite Zenerdiode dient zur Begrenzung einer positiven Anschlussspannung auf einen Maximalwert und dient insbesondere zur Energieaufnahme positiver ESD-Pulse, wodurch eine Zerstörung der Schaltung verhindert wird. Wenn die positive Spannung am Anschluss die Zenerspannung der zweiten Zenerdiode und die Durchflussspannung der Bulk-Diode überschreitet, wird ein aus der zweiten Zenerdiode und der Bulk-Diode gebildeter Strompfad leitend und die Spannung am Eingang wird auf die Summe aus Zenerspannung und Diodendurchflussspannung begrenzt. Durch geeignete Wahl der Zenerspannung kann die Spannungsschwelle bis zum Einsetzen des Clamp-Mechanismus eingestellt werden.

In einer Weiterbildung der Erfindung nach Anspruch 3 weist die jeweilige Zenerdiode eine Durchbruchspannung in einem Bereich von 30V bis 50V und/oder die jeweilige Diode eine Durchbruchspannung in einem Bereich von 50V bis 60V auf. Eine derartige Dimensionierung ermöglicht den sicheren Betrieb über einen weiten Spannungsbereich, der gut auf die typischerweise auftretenden Störspannungen angepasst ist.

In einer Weiterbildung der Erfindung nach Anspruch 4 dient diese zum Überspannungsschutz eines Anschlusses einer Low-Side-Treiberstufe und eines Anschlusses einer High-Side-Treiberstufe, die gemeinsam ein Anschlusspaar zur differentiellen Signalübertragung bilden. Die Schaltungsanordnung ermöglicht einen wirksamen Schutz sowohl vor positiven als auch vor negativen Überspannungen, wobei bei den üblichen Stör- bzw. Überspannungsbeträgen kein Clamp-Mechanismus einsetzt und folglich keine Signalverfälschung auftritt. Dies ermöglicht eine sichere differentielle Signalübertragung auch in gestörten Umgebungen wie beispielsweise im Kraftfahrzeug.

In einer Weiterbildung der Erfindung nach Anspruch 5 dient diese zum Überspannungsschutz einer Sender/Empfänger-Schaltung für ein Bus-System, insbesondere für einen CAN-Bus.

Vorteilhafte Ausführungsformen der Erfindung sind in den Zeichnungen dargestellt und werden nachfolgend beschrieben. Hierbei zeigen schematisch:
- Fig. 1: ein Blockschaltbild einer integrierten Schaltung zur differentiellen Datenübertragung mit einer High-Side-Treiberstufe und einer Low-Side-Treiberstufe, deren Anschlüsse jeweils durch eine erfindungsgemäße Schaltungsanordnung vor Überspannung geschützt sind,
- Fig. 2: ein Schaltbild der Low-Side-Treiberstufe von Fig. 1 mit Überspannungsschutz,
- Fig. 3: ein Schaltbild der High-Side-Treiberstufe von Fig. 1 mit Überspannungsschutz und
- Fig. 4: ein Diagramm der Strom-Spannungs-Kennlinie zwischen den Anschlüssen der Treiberstufen von Fig. 1.

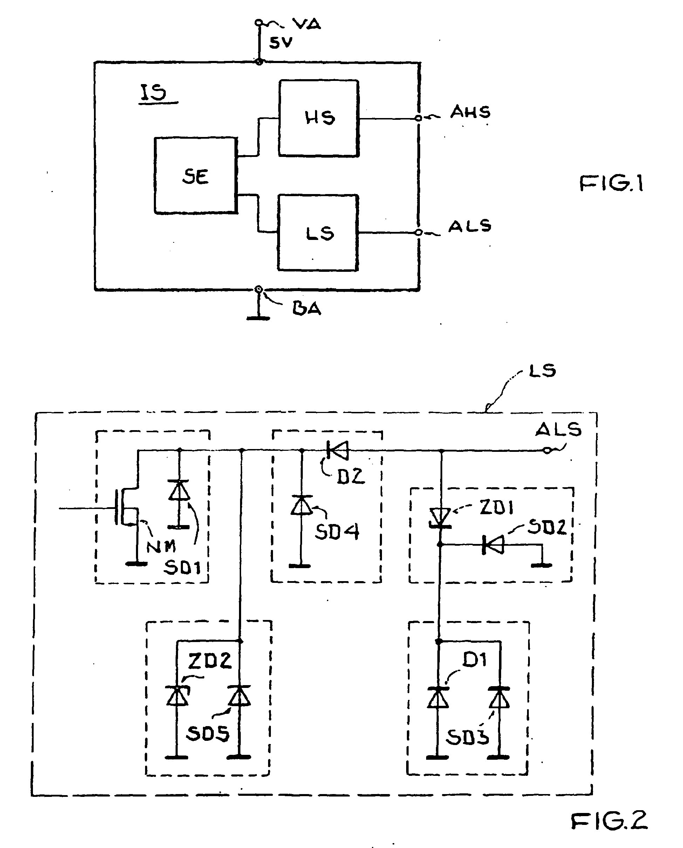

Fig. 1 zeigt ein Blockschaltbild einer integrierten Schaltung IS zur differentiellen Datenübertragung mit einer High-Side-Treiberstufe HS und einer Low-Side-Treiberstufe LS, deren Anschlüsse AHS und ALS jeweils durch eine erfindungsgemäße Schaltungsanordnung vor Überspannung geschützt sind. Die Treiberstufen LS und HS sind jeweils mit einer Sender/Empfänger-Einheit SE gekoppelt, die zur Ansteuerung der Treiberstufen HS und LS sowie zum Auswerten von Signalen an den Anschlüssen AHS und ALS dient. Die integrierte Schaltung IS wird über einen Versorgungsspannungsanschluss VA mit einer Versorgungsspannung von z.B. 5V versorgt. Eine Bezugsspannung von z.B. OV liegt an einem Bezugsspannungsanschluss BA an.

Fig. 2 zeigt ein Schaltbild der Low-Side-Treiberstufe LS von Fig. 1. Die Treiberstufe LS umfasst ein Schaltmittel in Form eines n-Kanal-MOSFET NM, der den Anschluss ALS in Abhängigkeit von einem durch die Sender/Empfänger-Einheit SE erzeugten Ansteuersignal mit dem Bezugspotential verbindet. Der n-Kanal-MOSFET NM weist eine Substrat- bzw. Bulk-Diode SD1 zwischen seinem Drain-Anschluß und Bezugspotential auf.

Eine Zenerdiode ZD1 und eine Diode D1 sind in Serie zwischen den Anschluss ALS und das Bezugspotential eingeschleift, wobei die Zenerdiode ZD1 in Flussrichtung und die Diode D1 in Sperrrichtung beschaltet sind. Die Zenerdiode ZD1 sowie die Diode D1 weisen eine Substrat-Diode SD2 bzw. SD3 in Sperrrichtung zwischen ihrer jeweiligen Kathode und Bezugspotential auf.

Die Diode D1 verhindert ein Durchschalten der Zenerdiode ZD1 bei positiven Spannungen am Anschluss ALS. Bei negativen Spannungen am Anschluss ALS arbeitet die Diode D1 in Durchlassrichtung und die Zenerdiode ZD1 in Sperrrichtung. Wenn die negative Spannung am Anschluss ALS die Zenerspannung der Zenerdiode ZD1 und die Durchflussspannung der Diode D1 überschreitet, wird der aus Zenerdiode ZD1 und Diode D1 gebildete Strompfad leitend und die Spannung am Anschluss ALS wird auf die Summe aus Zenerspannung und Diodendurchflussspannung begrenzt. Durch geeignete Wahl der Zenerspannung kann die Spannungsschwelle bis zum Einsetzen des Clamp-Mechanismus eingestellt werden.

Eine Diode D2, die zwischen den Anschluss ALS und den Drain-Anschluß des Transistors NM in Flussrichtung eingeschleift ist, verhindert bei negativen Anschlussspannungen einen Stromfluss durch die Substrat-Diode SD1 des n-Kanal-MOSFET. Die Diode D2 weist eine Substrat-Diode SD4 zwischen ihrer Kathode und Bezugspotential auf.

Eine Zenerdiode ZD2, die zwischen den Drain-Anschluß des Transistors NM und das Bezugspotential in Sperrrichtung eingeschleift ist, dient zur Begrenzung einer positiven Anschlussspannung auf einen Maximalwert. Die Zenerdiode ZD2 weist eine Substrat-Diode SD5 zwischen ihrer Kathode und Bezugspotential auf. Wenn die positive Spannung am Anschluss ALS die Zenerspannung der Zenerdiode ZD2 und die Durchflussspannung der Diode D2 überschreitet, wird der aus der Zenerdiode ZD2 und der Diode D2 gebildete Strompfad leitend und die Spannung am Anschluss ALS wird auf die Summe aus Zenerspannung und Diodendurchflussspannung begrenzt. Durch geeignete Wahl der Zenerspannung kann die Spannungsschwelle bis zum Einsetzen des Clamp-Mechanismus eingestellt werden.

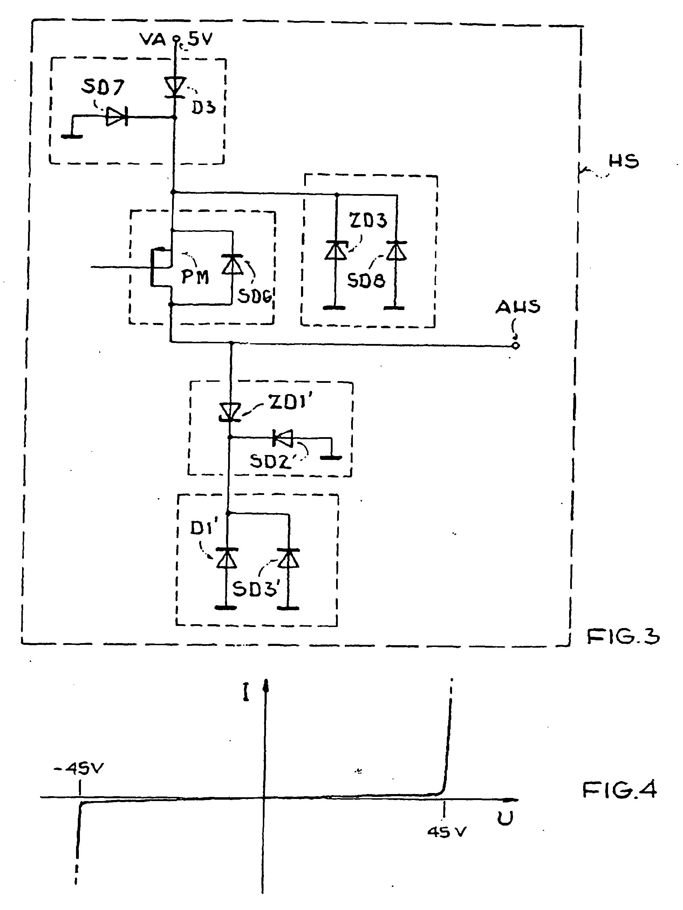

Fig. 3 zeigt ein Schaltbild der High-Side-Treiberstufe HS von Fig. 1. Die Treiberstufe HS umfasst ein Schaltmittel in Form eines p-Kanal-MOSFET PM, der den Anschluss AHS in Abhängigkeit von einem durch die Sender/Empfänger-Einheit SE erzeugten Ansteuersignal mit der Versorgungsspannung verbindet. Der p-Kanal-MOSFET PM weist eine Substrat- bzw. Bulk-Diode SD6 zwischen seinem Drain-Anschluss und seinem Source-Anschluss auf.

Eine Diode D3 ist zwischen die Versorgungsspannung und den Drain-Anschluß des Transistors PM in Flussrichtung eingeschleift und weist eine Substrat-Diode SD7 in Sperrrichtung zwischen ihrer Kathode und dem Bezugspotential auf. Sie verhindert bei positiven Anschlussspannungen, die größer als die Versorgungsspannung sind, einen Stromfluss durch die Substrat-Diode SD6 des p-Kanal-MOSFET PM in die Versorgungsspannung.

Eine Zenerdiode ZD3, die zwischen den Drain-Anschluß des Transistors PM und das Bezugspotential in Sperrrichtung eingeschleift ist, dient zur Begrenzung einer positiven Anschlussspannung auf einen Maximalwert. Die Zenerdiode ZD3 weist eine Substrat-Diode SD8 zwischen ihrer Kathode und Bezugspotential auf. Wenn die positive Spannung am Anschluss AHS die Zenerspannung der Zenerdiode ZD3 und die Durchflussspannung der Substrat-Diode SD6 überschreitet, wird der aus Zenerdiode ZD3 und Substrat-Diode SD6 gebildete Strompfad leitend und die Spannung am Eingang wird auf die Summe aus Zenerspannung und Diodendurchflussspannung begrenzt. Durch geeignete Wahl der Zenerspannung kann die Spannungsschwelle bis zum Einsetzen des Clamp-Mechanismus eingestellt werden.

Eine Zenerdiode ZD1', ihre zugehörige Substrat-Diode SD2', eine Diode D1' sowie ihre zugehörige Substrat-Diode SD3' entsprechen in ihrer Verschaltung, Funktion und Dimensionierung den in Fig. 2 gezeigten Bauelementen ZD1, SD2, D1 bzw. SD3.

Fig. 4 zeigt ein Diagramm der Strom-Spannungs-Kennlinie zwischen den Anschlüssen AHS und ALS von Fig. 1. Wie aus dem Diagramm ersichtlich ist, sind die Zenerdioden derart dimensioniert, dass ein Clamp-Mechanismus erst bei Signalamplituden von größer als ±45V einsetzt. Bei kleineren Signalamplituden werden die Eingangssignale praktisch nicht verfälscht, wodurch eine sichere Signalrückgewinnung aus dem Differenzsignal der Anschlüsse AHS und ALS gewährleistet ist.

Die vorliegende Erfindung ermöglicht, wie aus den oben beschriebenen Ausführungsbeispielen deutlich wird, eine wirksame Begrenzung von positiven und negativen Überspannungen an Anschlüssen einer integrierten Schaltung. Verfälschungen eines Nutzsignals durch Clamp-Mechanismen treten erst bei sehr hohen Überspannungen auf. Die Schaltungsanordnung ist kostengünstig herstellbar und in einfache Weise monolithisch integrierbar, da sie keine teuren Sonderbauelemente, beispielsweise substratfreie Poly-Elemente und keine aufwendigen Herstellungs-Technologien erfordert. Sie ist beispielsweise für CAN-Transceiver, aber auch für beliebige andere integrierte Sender/Empfänger-Schaltungen verwendbar, bei denen ein Überspannungsschutz gewünscht wird, der ohne externe Bauelemente zum Überspannungsschutz realisiert werden soll.

## Patentansprüche

1. Monolithisch integrierbare Schaltungsanordnung zum Überspannungsschutz eines oder mehrerer Anschlüsse (ALS) einer Low-Side-Treiberstufe (LS) einer integrierten Schaltung (IS), bei der dem jeweiligen Anschluss (ALS) ein n-Kanal-MOSFET (NM) zugeordnet ist, der den Anschluss (ALS) in Abhängigkeit von einem Ansteuersignal mit einem Bezugspotential der integrierten Schaltung (IS) verbindet,
**dadurch gekennzeichnet, dass**
für den Anschluss oder wenigstens einen der Anschlüsse (ALS) jeweils eine erste Zenerdiode (ZD1) und eine erste Diode (D1) vorgesehen sind, die in Serie zwischen den Anschluss (ALS) und das Bezugspotential eingeschleift sind, wobei die erste Zenerdiode (ZD1) in Flussrichtung und die erste Diode (D1) in Sperrrichtung beschaltet sind, eine zweite Diode (D2) zwischen diesen Anschluss (ALS) und einen Anschluss des n-Kanal-MOSFET in Flussrichtung eingeschleift ist und eine zweite Zenerdiode (ZD2) zwischen diesen Anschluss des n-Kanal-MOSFET und das Bezugspotential in Sperrrichtung eingeschleift ist.

2. Monolithisch integrierbare Schaltungsanordnung zum Überspannungsschutz eines oder mehrerer Anschlüsse (AHS) einer High-Side-Treiberstufe (HS) einer integrierten Schaltung (IS), bei der dem jeweiligen Anschluss (AHS) ein p-Kanal-MOSFET (PM) zugeordnet ist, der den Anschluss (AHS) in Abhängigkeit von einem Ansteuersignal mit einer Versorgungsspannung der integrierten Schaltung (IS) verbindet,
**dadurch gekennzeichnet, dass**
für den Anschluss oder wenigstens einen der Anschlüsse (AHS) jeweils eine erste Zenerdiode (ZD1') und eine erste Diode (D1') vorgesehen sind, die in Serie zwischen den Anschluss (AHS) und das Bezugspotential eingeschleift sind, wobei die erste Zenerdiode (ZD1') in Flussrichtung und die erste Diode (D1') in Sperrrichtung beschaltet sind, eine zweite Diode (D3) zwischen die Versorgungsspannung und einen Anschluss des p-Kanal-MOSFET (PM) in Flussrichtung eingeschleift ist und eine zweite Zenerdiode (ZD3) zwischen den Anschluss des p-Kanal-MOSFET und das Bezugspotential in Sperrrichtung eingeschleift ist.

3. Schaltungsanordnung nach Anspruch 1 oder 2, **dadurch gekennzeichnet, dass** die jeweilige Zenerdiode eine Durchbruchspannung in einem Bereich von 30V bis 50V und/oder die jeweilige Diode eine Durchbruchspannung in einem Bereich von 50V bis 60V aufweist.

4. Schaltungsanordnung nach einem der vorhergehenden Ansprüche**, dadurch gekennzeichnet, dass** sie zum Überspannungsschutz eines Anschlusses einer Low-Side-Treiberstufe (LS) und eines Anschlusses einer High-Side-Treiberstufe (HS) dient, die gemeinsam ein Anschlusspaar zur differentiellen Signalübertragung bilden.

5. Schaltungsanordnung nach einem der vorhergehenden Ansprüche, **dadurch gekennzeichnet, dass** sie zum Überspannungsschutz einer Sender/Empfänger-Schaltung für ein Bus-System, insbesondere für einen CAN-Bus, dient.

## Claims

1. Monolithic integratable circuit arrangement for excess voltage protection of one or more connections (ALS) of a low-side driver stage (LS) of an integrated circuit (IS), in which an n-channel MOSFET (NM) is associated with the respective connection (ALS) and connects the connection (ALS) with a reference potential of the integrated circuit (IS) in dependence on a drive control signal, **characterised in that** provided for the connection or at least one of the connections (ALS) is a respective Zener diode (ZD1) and a first diode (D1), which are connected in series between the connection (ALS) and the reference potential, wherein the first Zener diode (ZD1) is coupled in flow direction and the first diode (D1) in blocking direction, a second diode (D2) is connected between this connection (ALS) and a connection of the n-channel MOSFET in flow direction and a second Zener diode (ZD2) is connected between this connection of the n-channel MOSFET and the reference potential in blocking direction.

2. Monolithic integratable circuit arrangement for excess voltage protection of one or more connections (AHS) of a high-side driver stage (HS) of an integrated circuit (IS), in which a p-channel MOSFET (PM) is associated with the respective connection (AHS) and connects the connection (AHS) with a supply voltage of the integrated circuit (IS) in dependence on a drive control signal, **characterised in that** provided for the connection or at least one of the connections (AHS) is a respective Zener diode (ZD1') and a first diode (D1') which are connected in series between the connection (AHS) and the reference potential, wherein the first Zener diode (ZD1') is coupled in flow direction and the first diode (D1') in blocking direction, a second diode (D3) is connected between the supply voltage and a connection of the p-channel MOSFET (PM) in flow direction and a second Zener diode (ZD3) is connected between the connection of the p-channel MOSFET and the reference potential in blocking direction.

3. Circuit arrangement according to claim 1 or 2, **characterised in that** the respective Zener diode has a breakdown voltage in a range of 30V to 50V and/or the respective diode has a breakdown voltage in a range of 50V to 60V.

4. Circuit arrangement according to any one of the preceding claims, **characterised in that** it serves for excess voltage protection of the connection of a low-side driver stage (LS) and a connection of a high-side drive stage (HS), which together form a connection pair for differential signal transmission.

5. Circuit arrangement according to any one of the preceding claims, **characterised in that** it serves for excess voltage protection of a transmitter/receiver circuit for a bus system, particularly for a CAN bus.

## Revendications

1. Circuit intégré monolithique pour la protection contre les surtensions d'une ou de plusieurs bornes (ALS) d'un étage driver à bas potentiel (LS) d'un circuit intégré (IS), dans lequel à chaque borne (ALS) est associé un transistor MOS à canal du type N (NM), qui relie la borne (ALS) en fonction d'un signal pilote à un potentiel de référence du circuit intégré (IS), **caractérisé en ce que :**
pour la borne ou au moins une des bornes (ALS) on prévoit à chaque fois une première diode Zener (ZD1) et une première diode (D1), insérées en série entre la borne (ALS) et le potentiel de référence, la première diode Zener (ZD1) étant branchée dans le sens passant et la première diode (D1) dans le sens bloqué, une deuxième diode (D2) étant insérée dans le sens passant entre cette borne (ALS) et une borne du transistor MOS à canal du type N, et une deuxième diode Zener (ZD2) étant insérée dans le sens bloqué entre cette borne du transistor MOS à canal de type N et le potentiel de référence.

2. Circuit intégré monolithique pour la protection contre les surtensions d'une ou de plusieurs bornes (AHS) d'un étage driver à haut potentiel (HS) d'un circuit intégré (IS), dans lequel à chaque borne (AHS) est associé un transistor MOS à canal de type P (PM), qui relie la borne (AHS) en fonction d'un signal pilote à une tension d'alimentation du circuit intégré (IS), **caractérisé en ce que :**
pour la borne ou au moins une des bornes (AHS) on prévoit à chaque fois une première diode Zener (ZD1') et une première diode (D1') insérées en série entre la borne (AHS) et le potentiel de référence, la première diode Zener (ZD1') étant branchée dans le sens passant et la première diode (D1') dans le sens bloqué, une deuxième diode (D3) étant insérée dans le sens passant entre le potentiel de référence et une borne du transistor MOS à canal du type P (PM), et une deuxième diode Zener (ZD3) étant insérée dans le sens bloqué entre la borne du transistor MOS à canal de type P et le potentiel de référence.

3. Circuit selon la revendication 1 ou 2, **caractérisé en ce que** chacune des diodes Zener présente une tension de claquage située dans une zone s'étendant entre 30 et 50 V et/ou **en ce que** chacune des diodes présente une tension de claquage située dans une zone s'étendant entre 50 et 60 V.

4. Circuit selon l'une quelconque des revendications précédentes, **caractérisé en ce qu'**il sert à protéger une borne d'un étage driver à bas potentiel (LS) et une borne d'un étage driver à haut potentiel (HS) contre les surtensions, qui constituent ensemble une paire de bornes pour la transmission différentielle de signaux.

5. Circuit selon l'une quelconque des revendications précédentes, **caractérisé en ce qu'**il sert à protéger contre les surtensions un circuit émetteur/récepteur pour un système à bus, plus particulièrement pour un bus CAN.
